# EUROPÄISCHE PATENTANMELDUNG

(11) **EP 2 557 366 A2**
(43) Veröffentlichungstag der Anmeldung: **13.02.2013**
(21) Anmeldenummer: 12178861.6
(22) Anmeldetag: 01.08.2012
(51) Int. Cl.: F24D 19/10, F24F 11/00, G05D 23/19, H02N 2/18, F03G 7/08, H02J 17/00, H01L 35/00

(54) **Gebäudetechnische Anlage zum Heizen und/oder Kühlen**

(30) Priorität: 11.08.2011 DE 102011110030
(71) Anmelder: Vaillant GmbH, 42859 Remscheid (DE)
(72) Erfinder: Salg, Frank, 42897 Remscheid (DE); Sick, Jan-Hinrich, 38108 Braunschweig (DE); Spahn, Hans-Josef, 40699 Erkrath (DE)
(74) Vertreter: Hocker, Thomas

(57) **Zusammenfassung**

Die Erfindung betrifft eine Gebäudetechnische Anlage zum Heizen und/oder Kühlen von Gebäuden und/oder zur Warmwasserbereitung. Um den fehlerhaften Anschluss von Sensoren zu vermeiden, werden diese bereits bei der Herstellung eingebaut und konfiguriert. Die Sensoren werden durch Energie-Harvesting mit Energie versorgt und kommunizieren per Funk mit einem Steuergerät.

## Beschreibung

Die Erfindung betrifft eine gebäudetechnische Anlage zum Heizen und/oder Kühlen von Gebäuden und/oder zur Warmwasserbereitung.

Zur Regelung von gattungsgemäßen gebäudetechnischen Anlagen werden Sensoren benötigt, die ein Steuergerät mit Informationen über den Betriebszustand der Anlage versorgen. Die Montage der Sensoren auf der Baustelle verursacht Kosten und stellt ein Fehlerrisiko durch Vertauschung oder Beschädigung von Kabelverbindungen dar. Diese Fehler treten im Idealfall sofort zu Tage, können aber auch zu einem späteren Zeitpunkt zu einer Fehlfunktion der gebäudetechnischen Anlage führen.

Es ist daher Aufgabe der Erfindung, eine gebäudetechnische Anlage bereitzustellen, die die vorgenannten Nachteile vermeidet.

Diese Aufgabe wird dadurch gelöst, dass die Sensoren per Energie-Harvesting mit Energie versorgt werden und drahtlos an das Steuergerät angebunden sind. Unter Energie-Harvesting ist zu verstehen, dass der Sensor nicht über eine Versorgungsleitung mit einer Energieversorgung verbunden ist oder von einer Batterie mit Strom versorgt wird. Der Sensor ist mit einer Einrichtung verbunden, die aus der Umgebung oder Umwelt beispielsweise in Form von elektromagnetischen Feldern, Vibrationen oder Temperaturgradienten verfügbare Energie nutzt. Derartige Energie-Harvesting-Systeme sind beispielsweise aus der Patentschrift US 7,400,253 B2 und der Patentanmeldung WO 2010/093234 A2 bekannt. Die drahtlose Anbindung an das Steuergerät wird durch eine Kommunikation zwischen Sensor und Steuergerät per Funk realisiert.

Besonders vorteilhaft sind die Sensoren ab Werk bereits betriebsbereit vorkonfiguriert. Dies hat den Vorteil, dass eine fehlerträchtige Installation und Einstellung auf der Baustelle entfällt. Somit kann eine optimale Qualität sichergestellt werden.

Besonders bevorzugt wird für das Energie-Harvesting die von der gebäudetechnischen Anlagen gewandelte und/oder übertragene Energie genutzt. So wird beispielsweise bei einer Heizung die Temperaturdifferenz zwischen Heizung und Umgebung genutzt.

Die Erfindung wird nun anhand der Figur detailliert erläutert.

Es stellt dar:

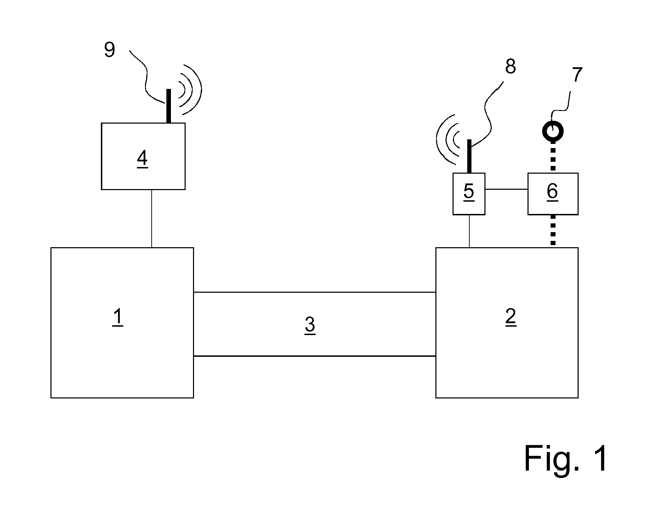

Figur 1: Funktionsschaltbild der gebäudetechnischen Anlage.

In Figur 1 ist das abstrakte Funktionsschaltbild der erfindungsgemäßen gebäudetechnischen Anlage dargestellt. Dabei besteht die gebäudetechnische Anlage aus einem ersten Mittel zur Energiewandlung 1 und einem zweiten Mittel zur Energiewandlung oder -speicherung 2, die durch ein Mittel zur Energieübertragung 3 miteinander verbunden sind. Beispielsweise kann das erste Mittel zur Energiewandlung 1 ein Brenner sein, während das zweite Mittel zur Energiewandlung oder -speicherung 2 ein Warmwasserspeicher ist. Das Mittel zur Energieübertragung 3 wird durch einen Heizkreis realisiert. Alternativ kann das zweite Mittel zur Energiewandlung oder -speicherung 2 ein Heizkörper sein. Ebenfalls ist durch dieses abstrakte Funktionsschaltbild auch eine Klimaanlage und andere heiz- und kühltechnische Anlagen darstellbar.

Mit dem ersten Mittel zur Energiewandlung 1 ist ein Steuergerät verbunden, das die Funktionen der gebäudetechnischen Anlage, insbesondere die Funktionen des ersten Mittels zur Energiewandlung 1 steuert. Mit dem zweiten Mittel zur Energiewandlung oder - speicherung 2 ist ein Sensor 5 verbunden, der einen oder mehrere Betriebszustände des zweiten Mittels zur Energiewandlung oder -speicherung 2 erfasst. Im Falle eines Warmwasserspeichers kann dies ein Temperaturfühler sein, der die verschiedenen Temperaturen in den einzelnen Speicherschichten des Warmwasserspeichers erfasst. Über die Antennen 8 und 9 kommunizieren der Sensor 5 und das Steuergerät 4 miteinander. Ein Energie-Harvester 6 gewinnt Energie aus der Umgebung und versorgt den Sensor 5 mit Energie. In diesem Beispiel kann aus dem Temperaturunterschied zwischen dem Warmwasserspeicher 2 und der Umgebung 7 Energie gewonnen werden. Um auch Betriebszustände abzudecken, in denen kein Temperaturunterschied vorliegt, kann die Energie auch in einem hier nicht dargestellten Pufferakku gespeichert werden, so dass sie kontinuierlich für den Sensor 5 vorliegt. Für den Fall, dass der Sensor 5 bereits werksseitig eingebaut und konfiguriert ist, ist ein geladener Pufferakku Voraussetzung für die erfolgreiche Inbetriebnahme. Eine Energie sparende Betriebsweise des Sensors 5 kann dadurch erreicht werden, dass der Sensor 5 nicht kontinuierlich sondern entweder in festen Zeitabständen oder bei schnellen Änderungen des Messsignals mit dem Steuergerät 4 kommuniziert. Erfindungsgemäß sind auch mehrere Sensoren 5 eingeschlossen. Sind die Sensoren 5 in die Mittel zur Energiewandlung oder -speicherung 2 ab Werk betriebsbereit eingebaut und integriert, so kann die Anlage besonders leicht ohne aufwändige Einbauten in Betrieb genommen werden.

### Bezugszeichenliste

- 1: Erstes Mittel zur Energiewandlung
- 2: Zweites Mittel zur Energiewandlung oder -speicherung
- 3: Mittel zur Energieübertragung
- 4: Steuergerät
- 5: Sensor
- 6: Energie-Harvester
- 7: Umgebung
- 8: Antenne des Sensors
- 9: Antenne des Steuergeräts

## Patentansprüche

1. Gebäudetechnische Anlage zum Heizen und/oder Kühlen von Gebäuden und/oder zur Warmwasserbereitung, mit einem ersten Mittel zur Energiewandlung (1) und mit einem zweiten Mittel zur Energiewandlung oder -speicherung (2), einem Mittel zur Energieübertragung (3), mit Sensoren (5) und mit einem Steuergerät (4), **dadurch gekennzeichnet, dass** die Sensoren (5) per Energie-Harvesting mit Energie versorgt werden und dass die Sensoren (5) drahtlos an das Steuergerät (4) angebunden sind.

2. Gebäudetechnische Anlage nach Anspruch 1, **dadurch gekennzeichnet, dass** die Sensoren (5) ab Werk betriebsbereit vorkonfiguriert sind.

3. Gebäudetechnische Anlage nach Anspruche 1 oder 2, **dadurch gekennzeichnet, dass** zur Energieversorgung der Sensoren (5) die von der gebäudetechnischen Anlage gewandelte und/oder übertragene Energie genutzt wird.

4. Gebäudetechnische Anlage nach einem der Ansprüche 1 bis 3, **dadurch gekennzeichnet, dass** die Sensoren (5) in die Mittel zur Energiewandlung oderspeicherung (2) integriert sind.
